# EUROPEAN PATENT SPECIFICATION

(11) **EP 4 475 143 B1**
(45) Date of publication and mention of the grant of the patent: **19.08.2026**
(21) Application number: 22959373.6
(22) Date of filing: 08.11.2022
(51) Int. Cl.: H10B 12/00, H10B 80/00

(54) **MEMORY AND STORAGE SYSTEM**
SPEICHER UND SPEICHERSYSTEM
MÉMOIRE ET SYSTÈME DE STOCKAGE

(30) Priority: 19.09.2022 CN 202211139805
(43) Date of publication of application: 11.12.2024
(73) Proprietor: CXMT Corporation, Hefei, Anhui 230601 (CN)
(72) Inventor: TANG, Yanzhe, Hefei, Anhui 230601 (CN)
(74) Representative: Gulde & Partner
(86) International application number: PCT/CN2022/130658
(87) International publication number: WO 2024/060371

(56) References cited:
- CN-A- 109 841 630
- US-A1- 2013 207 067
- US-A1- 2021 159 231
- US-A1- 2022 122 975
- US-A1- 2022 208 769

## Description

### CROSS-REFERENCE TO RELATED APPLICATIONS

The present disclosure is a continuation of PCT/CN2022/130658, filed on November 08, 2022, which claims priority to Chinese Patent Application No. 202211139805.5, filed on September 19, 2022, and entitled "MEMORY AND STORAGE SYSTEM'.

### TECHNICAL FIELD

The present disclosure relates to the field of semiconductor technologies, and relates to a memory and a storage system.

### BACKGROUND

With the continuous development of modem science and technology, semiconductor devices are widely applied to various electronic devices and electronic products. A dynamic random access memory (DRAM), as a volatile memory, is a semiconductor storage device commonly utilized in a computer.

The DRAM has a memory array including many repeated memory cells. A selection transistor and a storage structure connected to the selection transistor are included in each memory cell. Different statuses of the storage structure are configured to represent storage information, namely, "0" or "1". To improve the storage capability of the memory, the semiconductor device needs to have higher storage density and a smaller feature size. How to integrate more memory cells within a unit area and reduce an occupied area of each device, and how to improve electrical performance of the memory become urgent problems to be resolved in the industry.

Related arts can be found in US 2022/122975 A1, which relates to a memory device including a substrate; a bit line laterally oriented to be parallel to the substrate; a transistor including two channels that are laterally oriented from the bit line and a word line that is vertically oriented and surrounds the two channels; and a capacitor laterally oriented from the transistor.

### SUMMARY

The present disclosure is set out in the appended set of claims.

### BRIEF DESCRIPTION OF DRAWINGS

FIG. 1 is a schematic diagram of a memory according to an embodiment of the present disclosure;
FIG. 2 is a schematic diagram of another memory according to an embodiment of the present disclosure;
FIG. 3 is a schematic diagram of still another memory according to an embodiment of the present disclosure;
FIG. 4 is a schematic diagram of a memory bank, a control block, and a bit line structure layer in still another memory according to an embodiment of the present disclosure;
FIG. 5 is a schematic diagram of a sense amplifier circuit in still another memory according to an embodiment of the present disclosure;
FIG. 6 is a schematic diagram of a sub word line driver circuit in still another memory according to an embodiment of the present disclosure; and
FIG. 7 is a schematic diagram of a storage system according to an embodiment of the present disclosure.

### DESCRIPTION OF EMBODIMENTS

For ease of understanding of the present disclosure, example implementations of the present disclosure are described in more detail below with reference to the related accompanying drawings. Although the example implementations of the present disclosure are shown in the accompanying drawings, it should be understood that the present disclosure may be implemented in various forms without being limited by the specific implementations described herein. Instead, these implementations are provided to implement a more thorough understanding of the present disclosure and to fully convey the scope of the present disclosure to a person skilled in the art.

In the following descriptions, a large quantity of specific details are given to provide a more thorough understanding of the present disclosure. However, it is clear to a person skilled in the art that the present disclosure may be implemented without one or more of these details. In some embodiments, some technical features well-known in the art are not described to avoid confusion with the present disclosure. That is, all features of actual embodiments may not be described herein, and well-known functions and structures may not be described in detail.

Generally, terms may be at least partially understood from the utilization in the context, for example, at least partially depend on the context. For example, the term "one or more" utilized in this specification may be configured to describe any feature, structure, or characteristic in a singular sense, or may be configured to describe a combination of features, structures, or characteristics in a plural sense. Similarly, the terms such as "one" or "the" may also be understood as conveying singular usage or plural usage, at least partially depending on the context. In addition, the term "based on" may be understood as not necessarily intended to convey an exclusive group of factors, and may alternatively allow for the presence of additional factors that are not necessarily explicitly described, which also at least partially depends on the context.

Unless otherwise defined, the terms utilized in this specification are intended merely to describe specific embodiments and are not construed as a limitation to the present disclosure. As utilized herein, the singular forms "a/an", "one", and "the" are also intended to include plural forms unless the context clearly indicates otherwise. It should also be understood that the terms "constitute" and/or "include" are utilized in the specification to determine the presence of the feature, integer, step, operation, element, and/or component, but not rule out the presence or addition of one or more other features, integers, steps, operations, elements, components, and/or groups. As utilized herein, the term "and/or" includes any and all combinations of the related items listed.

For a thorough understanding of the present disclosure, detailed steps and detailed structures are provided in the following descriptions to illustrate the technical solutions of the present disclosure. Preferred embodiments of the present disclosure are described in detail as follows. However, the present disclosure may have other implementations in addition to these detailed descriptions.

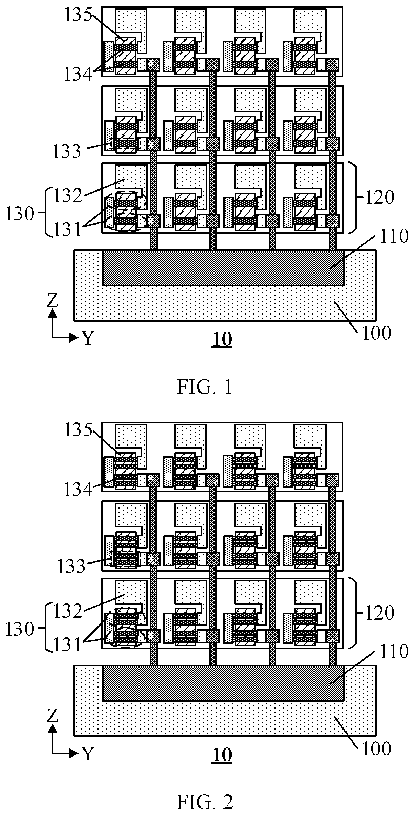

As shown in FIG. 1, an embodiment of the present disclosure which does not form part of the claimed invention, provides a memory 10, including a substrate 100; a control circuit layer 110 located in the substrate 100, at least a part of control circuits of the memory 10 being included in the control circuit layer 110; and at least two storage structure layers 120. The at least two storage structure layers 120 are sequentially stacked on the control circuit layer 110 in a first direction. The first direction is perpendicular to the surface of the substrate 100. The storage structure layer 120 is connected to the control circuit layer 110. The storage structure layer 120 includes multiple memory cells 130 arranged in an array. The memory cell 130 includes a storage structure 132 and at least two series-connected selection transistors 131 connected to the storage structure 132. The at least two series-connected selection transistors 131 are stacked in the first direction. A channel structure 133 of the selection transistor 131 includes at least one layer of nanosheets 134 extending in a second direction. The second direction is parallel to the surface of the substrate 100. The at least two series-connected selection transistors 131 share one gate structure 135.

In this embodiment of the present disclosure, the memory 10 may include but is not limited to a dynamic random access memory (DRAM), a static random access memory (SRAM), a ferroelectric random access memory (FRAM), a magnetoresistive random access memory (MRAM), a phase change random access memory (PCRAM), a resistive random access memory (RRAM), a nano random access memory (NRAM), and the like. The material of the substrate 100 may include a single semiconductor material, e.g., silicon (Si), germanium (Ge), or a compound semiconductor material, e.g., gallium nitride (GaN), gallium arsenide (GaAs), or indium phosphide (InP). The substrate 100 may be doped, or a doped region and an undoped region may be included in the substrate. It should be understood that, to clearly show each layer structure in the figure, a size proportion relationship of each layer structure may be inconsistent with that of an actual structure. It should be noted that the horizontal direction in the present disclosure is a direction parallel to the surface of the substrate 100, including but not limited to the X direction and the Y direction, and the vertical direction is a direction perpendicular to the surface of the substrate 100, e.g., the Z direction.

In some embodiments, the control circuit and a memory cell array in the memory are located in the same plane parallel to the surface of the substrate. In addition, the control circuit is located around the memory cell array in the horizontal direction. In this case, the occupied area of the memory in the horizontal direction is relatively large, and the integration level is relatively low. It may be understood that in this case, to obtain higher storage density, a size of the memory cell needs to be further reduced, and a process technology is relatively difficult. In addition, because a height difference between the control circuit and the memory cell array is relatively large in the vertical direction, and the control circuit and the memory cell array are formed in the same technology, a height of a conductive plug in the control circuit is relatively high, and a contact resistance is relatively large, which affects a drive current of the transistor. Consequently, the performance of the memory is relatively poor.

In this embodiment of the present disclosure, which does not form part of the claimed invention, as shown in FIG. 1, the control circuit layer 110 is located on the substrate 100, and the at least part of the control circuits of the memory 10 is included in the control circuit layer 110. For example, the control circuit layer 110 includes but is not limited to a sub word line driver (SWD), a sense amplifier (SA) circuit, a row decoder, a column decoder, a fuse repair circuit, a power supply circuit, a data input/output circuit, and the like. The control circuit layer 110 may be configured to decode, detect a memory cell, and control the memory cell to perform operations such as writing and reading data.

The at least two storage structure layers 120 sequentially stacked are located on the control circuit layer 110. To be specific, the at least two storage structure layers 120 are located on the surface of the control circuit layer 110 away from a side of the substrate 100, and are stacked in the first direction. The first direction herein may be the Z direction. The multiple memory cells 130 arranged in an array may be included in one storage structure layer 120, and each memory cell 130 may be connected to the control circuit layer 110 through a word line, a bit line, and another connection structure. The memory cell 130 may perform operations such as data write and read based on control signals sent by the control circuit layer 110. The at least two series-connected selection transistors 131, and the storage structure 132 connected to the at least two series-connected selection transistors 131 may be included in the memory cell 130. The selection transistor 131 is configured to control connectivity/interruption of a signal between the memory cell 130 and the control circuit layer 110. When writing data to and reading data from the memory cell 130, the selection transistor 131 needs to be switched to the conducting state, to change or obtain a storage status of the storage structure 132. Different storage statuses of the storage structure 132 are configured to indicate different data information. The storage structure 132 includes but is not limited to a storage capacitor, a magnetic tunnel junction (MTJ), a GeₓSb_{y}Te_{z} (GST) unit, and the like. In this way, the at least two storage structure layers 120 are stacked on the control circuit layer 110 in the direction perpendicular to the surface of the substrate 100, so that a three-dimensional storage structure is formed, and the area occupied by the memory 10 in the horizontal direction can be reduced without further reducing the size of the memory cell, which is conducive to improving the integration level. In addition, the storage structure layers 120 may be sequentially formed on the control circuit layer 110, and are not limited by technology processes such as the conductive plug, shallow trench isolation (STI), metal silicide, and the like. Therefore, manufacturing costs of the memory 10 can be reduced, and relatively good performance is ensured for each transistor in the control circuit and the memory cell array.

In this embodiment of the present disclosure, which does not form part of the claimed invention, as shown in FIG. 1, the at least two series-connected selection transistors 131 are stacked in the Z direction, and the at least one layer of nanosheets 134 are included in the channel structure 133 of each selection transistor 131. The length direction of the nanosheet 134 is the same as the length direction of the channel structure 133, and may be the second direction. The second direction herein may be the Y direction. The nanosheet 134 herein refers to a two-dimensional material having a nanometer-level layered structure, which has a continuous microscopic appearance, and a thickness being less than 10 nm. A current passing through the nanosheet may be increased by increasing the width of the nanosheet, and power consumption of a device may be reduced by reducing the width of the nanosheet. The nanosheet 134 may include but are not limited to silicon, silicon germanium (SiGe), and/or III-V semiconductor materials e.g., indium gallium arsenide (InGaAs), indium arsenide (InAs), or indium antimonide (InSb). The nanosheet 134 helps reduce the occupied area of the selection transistor 131 while maintaining the performance of the selection transistor 131. For example, the channel structures 133 of the two selection transistors 131 in the memory cell 130 may share one source/drain structure, so that the two selection transistors 131 are connected in series through the source/drain structure.

The at least two series-connected selection transistors 131 stacked in the Z direction may share one gate structure 135. The gate structure 135 may surround the channel structure 133 of each selection transistor 131. For example, the gate structure 135 may include a gate dielectric layer surrounding each layer of nanosheets 134 and a gate electrode covering the gate dielectric layer. In this way, the gate structure 135 forms multiple gate all around (GAA) structures stacked in the Z direction, to improve the control capability of the gate structure 135 on the channel structure 133. In this way, the gate structure 135 can simultaneously control conducting or cutoff of the at least two series-connected selection transistors 131. When the at least two series-connected selection transistors 131 are in the cutoff state, a leakage current of the channel structure 133 can be effectively reduced, and the possibility of a leakage phenomenon can be reduced, to improve the electrical performance of the selection transistor 131.

In some embodiments, which do not form part of the claimed invention, as shown in FIG. 2, at least two layers of nanosheets 134 may be included in the channel structure 133 of each selection transistor 131. In this way, when the channel structure 133 is conducting, currents flow through the at least two layers of nanosheets 134, that is, the effective width of the channel structure 133 is increased. In this way, a drive current can be increased when the selection transistor 131 is conducting, to improve the performance of the memory 10. It may be understood that the at least two layers of nanosheets 134 in the channel structure 133 may be stacked in the Z direction or may be stacked in another direction. This is not limited herein.

In some embodiments, more than two series-connected selection transistors 131 may be included in the memory cell 130. Two adjacent selection transistors 131 in the Z direction may be connected in series through a source/drain structure located at the first end or the second end of the channel structure 133 in the Y direction, thereby further reducing the possibility of occurrence of a leakage phenomenon. For example, three stacked selection transistors 131 may be connected in series by two source/drain structures, thereby constituting a series-connected structure similar to an "S" shape in the Y-Z-plane direction.

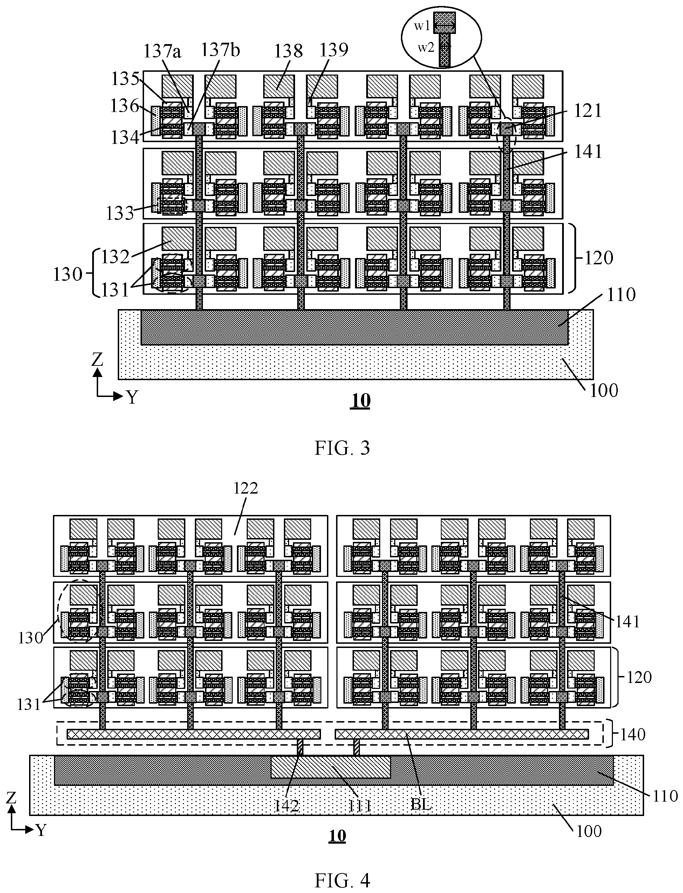

In some embodiments, which do not form part of the claimed invention, as shown in FIG. 3, the projections of the nanosheets 134 in the at least two series-connected selection transistors 131 on the substrate 100 overlap.

In an implementation of the present disclosure, the projections of the layers of nanosheets 134 on the substrate 100 overlap each other, that is, the layers of nanosheets 134 are aligned in the horizontal direction. In this way, the channel structures 133 of the at least two series-connected selection transistors 131 occupy a relatively small area in the horizontal direction, which is conducive to further reducing the occupied area of the memory cell 130.

In some embodiments, which do not form part of the claimed invention, as shown in FIG. 3, there is a gap between two adjacent layers of the nanosheets 134 in the first direction. The gate structure 135 surrounds each layer of the nanosheets 134 through the gap.

In an implementation of the present disclosure, there is a gap between the two adjacent layers of nanosheets 134 in the Z direction, and the gate structure 135 passes through these gaps and covers each layer of nanosheets 134, thereby constituting the gate all around structure, to improve the control capability of the gate structure 135 on the channel structure 133. It may be understood that the size of a gap between two adjacent layers of nanosheets 134 may be adjusted to meet the performance requirement of the memory 10 on the selection transistor 131. The size of the gap herein may be the distance between two adjacent layers of nanosheets 134 in the Z direction.

In some embodiments, which do not form part of the claimed invention, as shown in FIG. 3, the memory cell 130 further includes: a first source/drain structure 137a and a second source/drain structure 137b, respectively located at the first ends of the channel structures 133 of two of the selection transistors 131 in the second direction, the first source/drain structure 137a and the second source/drain structure 137b being stacked in the first direction; and a third source/drain structure 136, located at the second ends of the channel structures 133 of the two selection transistors 131 in the second direction. The two selection transistors 131 are connected in series through the third source/drain structure 136. The first source/drain structure 137a and the second source/drain structure 137b are respectively connected to the nanosheets 134 in the two series-connected selection transistors 131. The storage structure 132 is connected to the first source/drain structure 137a.

In this embodiment of the present disclosure, the first source/drain structure 137a and the second source/drain structure 137b may be located at the first ends of the channel structures 133 in the second direction, that is, the first source/drain structure 137a and the second source/drain structure 137b, and the third source/drain structure 136 are located at opposite ends in the second direction. The second direction herein may be the Y direction, that is, the length direction of the channel structure 133. The first source/drain structure 137a and the second source/drain structure 137b may be stacked in the Z direction to reduce the area occupied by the selection transistor 131 in the horizontal direction. For example, the first source/drain structure 137a is located above the second source/drain structure 137b. The first source/drain structure 137a and the second source/drain structure 137b may be doped semiconductor materials, e.g., doped Si and doped SiGe, and the doping types of the first source/drain structure 137a and the second source/drain structure 137b may be the same.

The third source/drain structure 136 may be located at the second ends of the channel structures 133 of the two series-connected selection transistors 131 in the Y direction. The material of the third source/drain structure 136 includes but is not limited to a doped semiconductor material, e.g., doped Si and doped SiGe. The two ends of the third source/drain structure 136 in the Z direction may be respectively connected to the nanosheets 134 in the stacked two selection transistors 131, that is, the two selection transistors 131 may share one third source/drain structure 136. In this way, the stacked two selection transistors 131 may be connected in series through the third source/drain structure 136.

The first source/drain structure 137a and the second source/drain structure 137b are respectively connected to the nanosheets 134 in the two series-connected selection transistors 131. In addition, the first source/drain structure 137a may be further connected to the storage structure 132, and the second source/drain structure 137b may be further connected to a structure such as a bit line in the memory 10. In this way, when the selection transistor 131 is conducting, a status of the storage structure 132 can be changed or detected by the bit line via the selection transistor 131, to perform operations such as writing and reading on the memory cell 130.

In some embodiments, which do not form part of the claimed invention, as shown in FIG. 3, the storage structure 132 includes: a storage capacitor 138, located on the side of the first source/drain structure 137a away from the substrate 100, a projected region of the storage capacitor 138 on the selection transistor 131 at least partially overlapping the region in which the selection transistor 131 is located; and a first connection structure 139, connected between the storage capacitor 138 and the first source/drain structure 137a.

In this embodiment of the present disclosure, the storage capacitor 138 and the first connection structure 139 may be included in the storage structure 132. The storage capacitor 138 is located on the side of the first source/drain structure 137a away from the substrate 100 in the Z direction, that is, the storage capacitor 138 is located above the first source/drain structure 137a in FIG. 3. The projection of the storage capacitor 138 on the selection transistor 131 at least partially overlaps the region in which the selection transistor 131 is located, to reduce the occupied area of the memory cell 130 in the horizontal direction and increase the quantity of memory cells 130 in a unit area of the storage structure layer. The storage capacitor 138 is connected to the first source/drain structure 137a through the first connection structure 139, that is, the first connection structure 139 may serve as a landing pad. The material of the first connection structure 139 includes but is not limited to conductive materials such as copper, tungsten, doped polysilicon, and metal silicide.

For example, the memory cell 130 in this embodiment of the present disclosure may have a structure of "1T1C" (one selection transistor and one storage capacitor). The selection transistor 131 is configured to switch connectivity/interruption of a signal between the control circuit and the memory cell 130. When writing data to and reading data from the memory cell 130, the selection transistor 131 needs to be switched to the conducting state, to implement charge transfer between the storage capacitor 138 and the outside. The storage capacitor 138 achieves the function of storing data based on stored charges. Because the potentials at the electrodes of the storage capacitor 138 vary with charges stored in the storage capacitor 138, binary data read/write can be achieved by switching the storage status of the storage capacitor 138. For example, data "1" is represented when the storage capacitor 138 is in the charged state, and data "0" is represented when the storage capacitor 138 is in the discharged state (the uncharged state). By detecting the voltage on the electrode of the storage capacitor 138, it may be determined that the status of the storage capacitor 138 is the charged state or the discharged state (the uncharged state), thereby implementing data read.

In some embodiments, which do not form part of the claimed invention, as shown in FIG. 3, the memory further includes a first connection line 141, located between two adjacent storage structure layers 120. The second source/drain structures 137b of the two adjacent memory cells 130 in the first direction are connected through the first connection line 141.

In this embodiment of the present disclosure, there may be multiple first connection lines 141 between the two adjacent storage structure layers 120 in the Z direction. The first connection line 141 may extend in the Z direction. The material of the first connection line 141 includes but is not limited to conductive materials such as copper, tungsten, doped polysilicon, and metal silicide. The first connection line 141 is configured to connect to the second source/drain structures 137b of the two adjacent memory cells 130 in the Z direction. It may be understood that second source/drain structures 137b of multiple memory cells 130 located on the same straight line in the Z direction may be connected together through the first connection lines 141, and then connected to the same bit line. In this way, the multiple memory cells 130 in different storage structure layers 120 can be operated by one bit line through the first connection lines 141.

In some embodiments, one first connection line 141 may penetrate two or more storage structure layers 120, and be connected to the multiple second source/drain structures 137b located on the same straight line in the Z direction. That is, one first connection line 141 may not be limited to connecting memory cells 130 in two adjacent storage structure layers 120.

In some embodiments, which do not form part of the claimed invention, as shown in FIG. 3, the second source/drain structures 137b of the two adjacent memory cells 130 in the second direction are connected to the same first connection line 141. The two memory cells 130 connected to the same first connection line 141 and adjacent in the second direction are symmetrically disposed with respect to the first connection line 141.

In this embodiment of the present disclosure, second source/drain structures 137b of two adjacent memory cells 130 in the Y direction may be connected to the same first connection line 141. In addition, the two memory cells 130 may be axisymmetrically distributed with respect to the first connection line 141. In this way, the wiring design of the storage structure layer 120 can be optimized, to reduce space. In addition, the storage structures of the two memory cells 130 adjacent in the same storage structure layer 120 may be simultaneously operated by the bit line through one first connection line 141, thereby improving the working efficiency of the memory 10. It should be noted that the two memory cells 130 herein may also be centrosymmetrically distributed by utilizing a connection point of the first connection line 141 as the center. Certainly, in actual application, another distribution location may be designed according to a specific requirement.

In some embodiments, the two adjacent memory cells 130 in the Y direction may share the same second source/drain structure 137b. In addition, the two memory cells 130 may be symmetrically disposed with respect to the second source/drain structure 137b. In this way, the first connection line 141 can be connected to the two memory cells 130 through the shared second source/drain structure 137b.

In some embodiments, which do not form part of the claimed invention, as shown in FIG. 3, the second source/drain structures 137b of the two adjacent memory cells 130 in the second direction are connected to the same first connection line 141 through a second connection structure 121. The projected area of the second connection structure 121 on the substrate 100 is greater than the projected area of the first connection line 141 on the substrate 100.

In this embodiment of the present disclosure, the two adjacent memory cells 130 in the Y direction have respective second source/drain structures 137b. In addition, there is the second connection structure 121 between the second source/drain structures 137b of the two memory cells 130. The two ends of the second connection structure 121 in the Y direction may be respectively connected to the two second source/drain structures 137b, and the two ends of the second connection structure 121 in the Z direction may be connected to the first connection line 141. That is, the second source/drain structures 137b of the two adjacent memory cells 130 in the Y direction are connected to the same first connection line 141 through the second connection structure 121. The material of the second connection structure 121 herein includes but is not limited to conductive materials such as copper, tungsten, doped polysilicon, and metal silicide.

The projected area of the second connection structure 121 on the substrate 100 may be greater than the projected area of the first connection line 141 on the substrate 100, thereby reducing the contact resistance between the second connection structure 121 and the first connection line 141 and increasing the current, to improve the drive capability of the memory. For example, as shown in FIG. 3, in the Y-Z-plane direction, the width w1 of the second connection structure 121 is greater than the width w2 of the first connection line 141. The sections of the second connection structure 121 and the first connection line 141 herein may be circular, and therefore, the width may also be understood as the diameter. In another embodiment, the sections of the second connection structure 121 and the first connection line 141 may alternatively be in another shape, provided that the projected area of the first connection structure 121 on the substrate is greater than that of the first connection line 141.

In embodiments, which are in accordance with the claimed invention, as shown in FIG. 4, the memory 10 further includes a bit line structure layer 140, located between the lowest storage structure layer 120 and the control circuit layer 110. The bit line structure layer 140 includes multiple parallel bit lines (BL) extending in a third direction. The third direction is parallel to the surface of the substrate 100. Each of the bit lines (BL) is connected to multiple groups of memory cells 130 arranged in the third direction. Each group of memory cells 130 are multiple memory cells 130 that are stacked in the direction perpendicular to the surface of the substrate 100 and that are connected through the first connection line 141. In this embodiment of the present disclosure, there is further the bit line structure layer 140 between the lowest storage structure layer 120 and the control circuit layer 110. In addition, the multiple bit lines (BL) extending in the third direction are included in the bit line structure layer 140. The third direction herein may be the Y direction, or may be another direction that has the included angle with the X direction.

The at least two storage structure layers 120 have multiple groups of memory cells 130 arranged in the Y direction. Herein, the multiple memory cells 130 connected to the multiple first connection lines 141 located on the same straight line in the Z direction form the same group of memory cells, that is, the multiple memory cells 130 in each group of memory cells are located in different storage structure layers 120, and are stacked in the Z direction.

The same bit line (BL) may provide an electrical connection to the multiple groups of memory cells 130 arranged in the Y direction. For example, selection transistors in the two adjacent memory cells 130 in the Y direction in the same storage structure layer 120 are connected to the same first connection line 141. The multiple first connection lines 141 located on the same straight line in the Z direction are connected to the same bit line (BL). The bit line (BL) is connected to the control circuit layer 110 through a second connection line 142.

Because there are at least two storage structure layers 120, the memory cells 130 in this embodiment of the present disclosure are arranged in a three-dimensional structure array on the substrate 100 and the control circuit layer 110. That is, multiple memory cells 130 on one surface are included in the memory cells 130 connected to the bit line (BL).

Relative to the memory cells 130 connected to the same bit line (BL), individual gating may be performed on the selection transistor of each memory cell 130, to implement the separate control on each memory cell 130.

The control circuit layer 110 may include a circuit and a device connected to the bit line (BL) and performing a read/write operation on each memory cell 130 through the bit line (BL). Because the bit line (BL) extends in the first direction parallel to the surface of the substrate 100, the second connection line 142 perpendicular to the substrate herein further needs to be connected between the bit line (BL) and the control circuit layer 110.

In some embodiments, as shown in FIG. 4, the storage structure layer 120 includes multiple memory banks 122. The memory bank 122 includes the multiple memory cells 130. The control circuit layer 110 includes multiple control blocks 111 correspondingly connected to each of the memory banks 122. Each of the bit lines (BL) is connected to the control block 111 and the multiple groups of memory cells 130 in the multiple memory banks 122.

In this embodiment of the present disclosure, multiple memory banks 122 may be included in each storage structure layer 120, and there are the multiple memory cells 130 arranged in an array in the memory bank 122. The memory bank 122 herein may be a memory array tile (MAT). The memory bank 122 may be connected to the control block 111 in the control circuit layer 110. Write and read operations may be performed by the control block 111 on the multiple memory cells 130 in the memory bank 122 through a word line, a bit line, and another connection structure. It may be understood that the connection relationship between the control block 111 and the memory bank 122 may be a one-to-one correspondence, or may be a one-to-many, many-to-one, or many-to-many relationship.

Each bit line (BL) may be connected to the control block 111 and the multiple groups of memory cells 130 in the multiple memory banks 122. For example, the bit line (BL) is connected to the control block 111 through the second connection line 142, and is connected to the multiple groups of memory cells 130 through the first connection line 141.

It should be noted that multiple memory banks 122 stacked in the Z direction may form one group of memory banks 122. The memory 10 may have multiple groups of memory banks 122 in the Y direction. Multiple groups of memory cells 130 may be included in each group of memory banks 122. Multiple groups of memory cells 130 connected to one bit line (BL) herein may be located in the same group of memory banks 122, or may be located in multiple groups of memory banks 122.

In some embodiments, as shown in FIG. 4, the region in which the control block 111 is located at least partially overlaps the projected region, on the control circuit layer 110, of the memory bank 122 connected to the control block 111. That is, at least a part of the region of each control block 111 is located below the memory bank 122 to which the control block 111 is connected, thereby facilitating planning and wiring, and improving the spatial utilization of each connection structure.

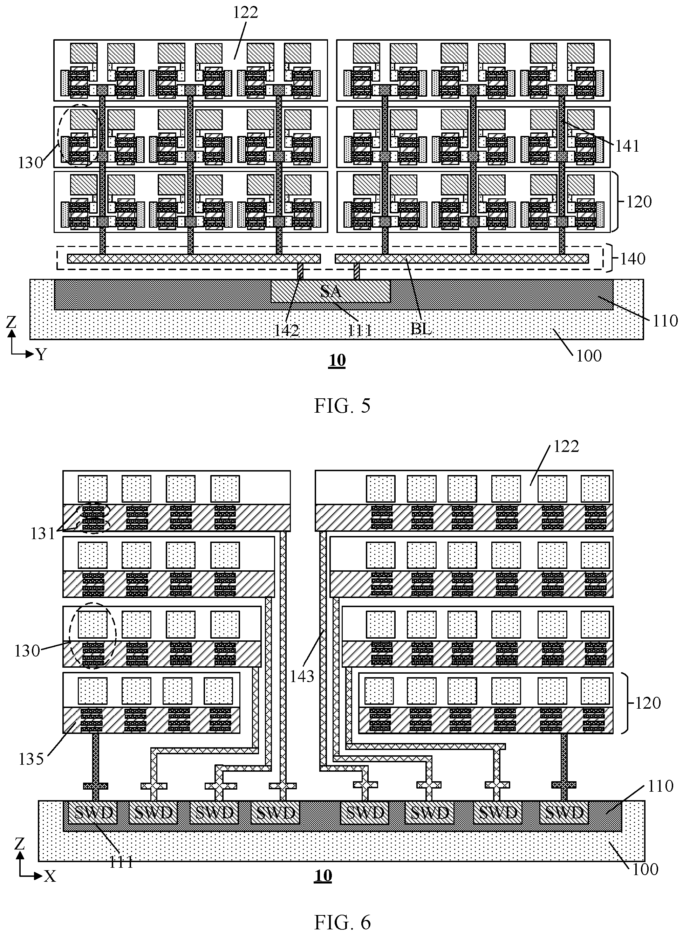

In some embodiments, as shown in FIG. 5, the control block 111 includes a first control block connected to the bit line (BL).

In this embodiment of the present disclosure, the control block 111 may include a first control block connected to the bit line (BL). The first control block herein includes but is not limited to an SA in FIG. 5. The SA may also be referred to as a sense amplifier, and is configured to amplify a small potential difference between a target bit line and a reference bit line in a process of performing reading/writing on the memory cell 130. Herein, the target bit line may be a bit line (BL) connected to a selection transistor of a memory cell 130 on which reading/writing is currently performed, and the reference bit line may be any other bit line (BL) connected to the same SA as the target bit line. In this case, a memory cell 130 connected to the reference bit line does not participate in data read/write. In this embodiment of the present disclosure, every two bit lines (BL) may be connected to the same SA. When data read/write is performed on a memory cell 130 connected to a first bit line (BL), the bit line is a target bit line, and the other bit line (BL) may serve as a reference bit line.

For example, when data read is performed on a memory cell 130, a selection transistor of the memory cell 130 is turned on. In this case, the charge stored in the memory cell 130 affects the potential of a target bit line connected to the memory cell 130, so that a small potential difference is generated between the target bit line and a reference bit line. The potential difference is amplified by the SA and is reflected in the target bit line and the reference bit line. In this way, data can be read by detecting the difference between the voltages on the target bit line and the reference bit line.

Herein, the bit line (BL) may be connected to the SA in the control block 111 through the second connection line 142.

In some embodiments, as shown in FIG. 6, the gate structures 135 of the multiple memory cells 130, in the memory bank 122, located on the same straight line extending in a fourth direction are interconnected and connected to the control block 111. The fourth direction is parallel to the surface of the substrate 100.

In this embodiment of the present disclosure, the gate structures 135 of the multiple memory cells 130, in the memory bank 122, located on the same straight line extending in the fourth direction are interconnected. The fourth direction herein may be the X direction. In this way, the interconnected gate structures 135 form a local word line in the memory bank 122, that is, one local word line may be coupled to the selection transistors 131 of the multiple memory cells 130, in the memory bank 122, located in the extending direction of the local word line, so that the multiple selection transistors 131 are conducting or cutoff based on a control signal sent by the control circuit layer 110, to complete operations such as data write and read. It may be understood that there is the included angle between the fourth direction and the third direction, that is, the projections of the bit line (BL) and the word line on the substrate intersect, to facilitate the wiring design of the memory 10.

In some embodiments, there is an opening between two adjacent memory banks 122 in the X direction. The projections of openings in multiple storage structure layers 120 on the substrate 100 at least partially overlap. The through openings have multiple third connection lines 143 extending in the Z direction. In this way, the interconnected gate structures 135 (namely, the local word line) in the memory bank 122 can be connected to the control block 111 in the control circuit layer 110 through the third connection lines 143 running through the multiple storage structure layers 120, thereby simplifying the wiring design of the memory 10.

In some embodiments, as shown in FIG. 6, the control block 111 includes a second control block connected to the gate structure 135.

In this embodiment of the present disclosure, the second control block connected to the gate structure 135 may be included in the control block 111. The second control block herein includes but is not limited to an SWD in FIG. 5. The SWD may be configured to drive the local word line in each memory bank 122, namely, the multiple gate structures 135 interconnected in the fourth direction, to provide a gating signal for each memory cell 130. In some embodiments, for the multiple memory banks 122, there may also be a global word line connected to multiple local word lines. It may be understood that one SWD may be connected to one local word line, and is configured to conduct the selection transistor 131 of each memory cell 130 connected to the local word line.

For the memory cell 130 on which reading/writing is to be performed, namely, a target memory cell, it is only necessary to provide a drive signal by an SWD corresponding to the target memory cell, and multiple memory cells 130 connected to a local word line on which the target memory cell is located are conducted through the local word line connected to the SWD. In addition, a corresponding data signal is provided for a bit line connected to the target memory cell, to implement an independent read/write operation on the target memory cell.

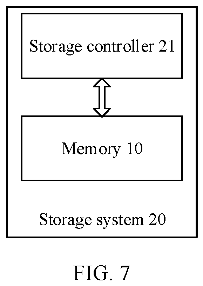

As shown in FIG. 7, an embodiment of the present disclosure further provides a storage system 20, including: the memory 10 in any one of the foregoing embodiments; and a storage controller 21. The storage system 20 may be any memory chip. The memory 10 may be controlled by the storage controller 21 to perform various operations based on signals sent by a host. It may be understood that, because the storage structure layer and the control circuit layer that are stacked are adopted, the integration level of the storage system 20 is relatively high. In addition, a first channel structure and a second channel structure of nanosheets are two segments of channels connected in series, and conduction or cutoff of the channel structure is controlled by one gate structure, which is conducive to reducing a leakage phenomenon of the channel and improving the electrical performance of the selection transistor.

It should be understood that "an embodiment" or "some embodiment" mentioned throughout the specification means that specific features, structures, or characteristics related to the embodiments are included in at least one embodiment of the present disclosure. Therefore, "in an embodiment" or "in some embodiment" occurring throughout the specification does not necessarily refer to the same embodiment.

It should be noted that in this specification, the terms "include", "comprise", or any other variant thereof are intended to cover non-exclusive inclusion, so that a process, method, article, or apparatus including a series of elements includes not only those elements but also other elements that are not expressly listed, or further includes elements inherent to such a process, method, article, or apparatus. An element preceded by "includes a ..." does not, without more constraints, preclude the presence of additional identical elements in the process, method, article, or apparatus that includes the element.

The protection scope of the present disclosure shall be subject to the protection scope of the claims.

### Industrial applicability

In the memory provided in the embodiments of the present disclosure, the at least two storage structure layers are sequentially stacked on the control circuit layer, and the at least two series-connected selection transistors in the memory cell are stacked. In addition, the channel structure of the selection transistor includes the at least one layer of nanosheets, and the at least two series-connected selection transistors share one gate structure. **In** this way, on the one hand, the occupied area of the storage structure layer and the control circuit layer that are stacked is relatively small, thereby improving the integration level of the memory. On the other hand, there are nanosheets in the channel structures of the at least two series-connected selection transistors, and conduction or cutoff of the two selection transistors is controlled by the same gate structure, which is conducive to reducing a leakage phenomenon of the channel and improving the electrical performance of the selection transistor.

## Claims

1. A memory (10), comprising:
a substrate (100);
a control circuit layer (110) located in the substrate (100), the control circuit layer (110) comprising at least a part of control circuits of the memory (10); and
at least two storage structure layers (120), the at least two storage structure layers (120) being sequentially stacked on the control circuit layer (110) in a first direction (Z), the first direction being perpendicular to a surface of the substrate (100), and the storage structure layer (120) being connected to the control circuit layer (110);
the storage structure layer (120) comprising a plurality of memory cells (130) arranged in an array, the memory cell (130) comprising a storage structure (132) and at least two series-connected selection transistors (131) connected to the storage structure (132), and the at least two series-connected selection transistors (131) being stacked in the first direction;
a channel structure (133) of the selection transistor (131) comprising at least one layer of nanosheets (134) extending in a second direction (Y), and the second direction being parallel to the surface of the substrate (100); and
the at least two series-connected selection transistors (131) sharing one gate structure (135);
wherein the memory cell (130) further comprises:
a first source/drain structure (137a) and a second source/drain structure (137b), respectively located at first ends of the channel structures (133) of two of the selection transistors (131) in the second direction, the first source/drain structure (137a) and the second source/drain structure (137b) being stacked in the first direction; and
a third source/drain structure (136), located at second ends of the channel structures (133) of the two selection transistors (131) in the second direction, the two selection transistors (131) being connected in series through the third source/drain structure (136); and
the first source/drain structure (137a) and the second source/drain structure (137b) are respectively connected to the nanosheets (134) in the two series-connected selection transistors (131), and the storage structure (132) is connected to the first source/drain structure (137a);
**characterized in that** the memory further comprises
a first connection line (141), located between two adjacent storage structure layers (120), wherein the second source/drain structures (137b) of two adjacent memory cells (130) in the first direction are connected through the first connection line (141);
a bit line structure layer (140), located between the lowest storage structure layer (120) and the control circuit layer (110), wherein the bit line structure layer (140) comprises a plurality of parallel bit lines (BL) extending in a third direction (X), the third direction is parallel to the surface of the substrate (100); and
each of the bit lines (BL) is connected to a plurality of groups of memory cells (130) arranged in the third direction, each group of memory cells (130) being a plurality of memory cells (130) that are stacked in a direction perpendicular to the surface of the substrate (100) and that are connected through the first connection line (141).

2. The memory according to claim 1, **characterized in that**, projections of the nanosheets (134) in the at least two series-connected selection transistors (131) on the substrate (100) overlap.

3. The memory according to claim 1, **characterized in that**, there is a gap between two adjacent layers of the nanosheets (134) in the first direction; and the gate structure (135) surrounds each layer of the nanosheets (134) through the gap.

4. The memory according to claim 1, the storage structure (132) **characterized by** comprises:
a storage capacitor (138), located above the first source/drain structure (137a), a projected region of the storage capacitor (138) on the selection transistor (131) at least partially overlapping a region in which the selection transistor (131) is located; and
a first connection structure (139), connected between the storage capacitor (138) and the first source/drain structure (137a).

5. The memory according to claim 1, **characterized in that**, the second source/drain structures (137b) of two adjacent memory cells (130) in the second direction are connected to a same first connection line (141); and
the two memory cells (130) connected to the same first connection line (141) and adjacent in the second direction are symmetrically disposed with respect to the first connection line (141).

6. The memory according to claim 5, **characterized in that**, the second source/drain structures (137b) of the two adjacent memory cells (130) in the second direction are connected to the same first connection line (141) through a second connection structure (121); and
a projected area of the second connection structure (121) on the substrate (100) is greater than a projected area of the first connection line (141) on the substrate (100).

7. The memory according to claim 1, the storage structure layer (120) **characterized by** comprises a plurality of memory banks (122); the memory bank (122) comprises a plurality of memory cells (130);
the control circuit layer (110) comprises a plurality of control blocks (111) correspondingly connected to each memory bank (122); and
each of the bit lines (BL) is connected to the control block (111) and a plurality of groups of memory cells (130) in the plurality of memory banks (122).

8. The memory according to claim 7, **characterized in that**, a region in which the control block (111) is located at least partially overlaps a projected region, on the control circuit layer (110), of the memory bank (122) to which the control block (111) is connected.

9. The memory according to claim 7, the control block (111) **characterized by** comprises:
a first control block connected to the bit line (BL).

10. The memory according to claim 7, **characterized in that**, the gate structures (135) of the plurality of the memory cells (130), in the memory bank (122), located on a same straight line extending in a fourth direction are interconnected and connected to the control block (111); and the fourth direction is parallel to the surface of the substrate (100).

11. The memory according to claim 10, the control block (111) **characterized by** comprises:
a second control block connected to the gate structure (135).

12. A storage system (20), **characterized by** comprising:
the memory (10) according to any one of claims 1 to 11; and
a storage controller (21).

## Patentansprüche

1. Speicher (10), umfassend:
ein Substrat (100);
eine Steuerschaltkreis-Schicht (110), die sich im Substrat (100) befindet, wobei die Steuerschaltkreis-Schicht (110) mindestens einen Teil der Steuerschaltkreise des Speichers (10) umfasst; und
mindestens zwei Speicherstruktur-Schichten (120), wobei die mindestens zwei Speicherstruktur-Schichten (120) in einer ersten Richtung (Z) sequentiell auf der Steuerschaltkreis-Schicht (110) gestapelt sind,
wobei die erste Richtung senkrecht zu einer Oberfläche des Substrats (100) verläuft und die Speicherstruktur-Schicht (120) mit der Steuerschaltkreis-Schicht (110) verbunden ist;
wobei die Speicherstruktur-Schicht (120) eine Vielzahl von Speicherzellen (130) umfasst, die in einer Matrix angeordnet sind, wobei die Speicherzelle (130) eine Speicherstruktur (132) und mindestens zwei in Reihe geschaltete Auswahltransistoren (131) umfasst, die mit der Speicherstruktur (132) verbunden sind, und wobei die mindestens zwei in Reihe geschalteten Auswahltransistoren (131) in der ersten Richtung gestapelt sind;
eine Kanalstruktur (133) des Auswahltransistors (131), die mindestens eine Schicht von Nanosheets (134) umfasst, die sich in einer zweiten Richtung (Y) erstrecken,
und wobei die zweite Richtung parallel zur Oberfläche des Substrats (100) verläuft; und
wobei die mindestens zwei in Reihe geschalteten Auswahltransistoren (131) eine gemeinsame Gate-Struktur (135) aufweisen;
wobei die Speicherzelle (130) ferner Folgendes umfasst:
eine erste Source/Drain-Struktur (137a) und eine zweite Source/Drain-Struktur (137b), die sich jeweils an ersten Enden der Kanalstrukturen (133) von zwei der Auswahltransistoren (131) in der zweiten Richtung befinden, wobei die erste Source/Drain-Struktur (137a) und die zweite Source/Drain-Struktur (137b) in der ersten Richtung gestapelt sind; und
eine dritte Source/Drain-Struktur (136), die sich an zweiten Enden der Kanalstrukturen (133) der zwei Auswahltransistoren (131) in der zweiten Richtung befindet, wobei die zwei Auswahltransistoren (131) über die dritte Source/Drain-Struktur (136) in Reihe geschaltet sind; und
wobei die erste Source/Drain-Struktur (137a) und die zweite Source/Drain-Struktur (137b) jeweils mit den Nanosheets (134) in den zwei in Reihe geschalteten Auswahltransistoren (131) verbunden sind, und wobei die Speicherstruktur (132) mit der ersten Source/Drain-Struktur (137a) verbunden ist;
**dadurch gekennzeichnet, dass** der Speicher ferner Folgendes umfasst:
eine erste Verbindungsleitung (141), die sich zwischen zwei benachbarten Speicherstruktur-Schichten (120) befindet, wobei die zweiten Source/Drain-Strukturen (137b) von zwei benachbarten Speicherzellen (130) in der ersten Richtung über die erste Verbindungsleitung (141) verbunden sind;
eine Bitleitungs-Strukturschicht (140), die sich zwischen der untersten Speicherstruktur-Schicht (120) und der Steuerschaltkreis-Schicht (110) befindet, wobei die Bitleitungs-Strukturschicht (140) eine Vielzahl von parallelen Bitleitungen (BL) umfasst, die sich in einer dritten Richtung (X) erstrecken,
wobei die dritte Richtung parallel zur Oberfläche des Substrats (100) verläuft; und
wobei jede der Bitleitungen (BL) mit einer Vielzahl von Gruppen von Speicherzellen (130) verbunden ist, die in der dritten Richtung angeordnet sind, wobei jede Gruppe von Speicherzellen (130) eine Vielzahl von Speicherzellen (130) ist, die in einer Richtung senkrecht zur Oberfläche des Substrats (100) gestapelt sind und über die erste Verbindungsleitung (141) verbunden sind.

2. Speicher nach Anspruch 1, **dadurch gekennzeichnet, dass** sich die Projektionen der Nanosheets (134) in den mindestens zwei in Reihe geschalteten Auswahltransistoren (131) auf dem Substrat (100) überlappen.

3. Speicher nach Anspruch 1, **dadurch gekennzeichnet, dass** zwischen zwei benachbarten Schichten der Nanosheets (134) in der ersten Richtung ein Spalt vorhanden ist; und wobei die Gate-Struktur (135) jede Schicht der Nanosheets (134) durch den Spalt umgibt.

4. Speicher nach Anspruch 1, wobei die Speicherstruktur (132) durch Folgendes gekennzeichnet ist: einen Speicherkondensator (138), der sich oberhalb der ersten Source/Drain-Struktur (137a) befindet, wobei sich ein Projektionsbereich des Speicherkondensators (138) auf dem Auswahltransistor (131) zumindest teilweise mit einem Bereich überlappt, in dem sich der Auswahltransistor (131) befindet; und
eine erste Verbindungsstruktur (139), die zwischen dem Speicherkondensator (138) und der ersten Source/Drain-Struktur (137a) verbunden ist.

5. Speicher nach Anspruch 1, **dadurch gekennzeichnet, dass** die zweiten Source/Drain-Strukturen (137b) von zwei in der zweiten Richtung benachbarten Speicherzellen (130) mit derselben ersten Verbindungsleitung (141) verbunden sind; und
wobei die zwei Speicherzellen (130), die mit derselben ersten Verbindungsleitung (141) verbunden und in der zweiten Richtung benachbart sind, symmetrisch bezüglich der ersten Verbindungsleitung (141) angeordnet sind.

6. Speicher nach Anspruch 5, **dadurch gekennzeichnet, dass** die zweiten Source/Drain-Strukturen (137b) der zwei in der zweiten Richtung benachbarten Speicherzellen (130) über eine zweite Verbindungsstruktur (121) mit derselben ersten Verbindungsleitung (141) verbunden sind; und
wobei eine Projektionsfläche der zweiten Verbindungsstruktur (121) auf dem Substrat (100) größer ist als eine Projektionsfläche der ersten Verbindungsleitung (141) auf dem Substrat (100).

7. Speicher nach Anspruch 1, wobei die Speicherstruktur-Schicht (120) durch eine Vielzahl von Speicherbänken (122) gekennzeichnet ist; wobei die Speicherbank (122) eine Vielzahl von Speicherzellen (130) umfasst;
wobei die Steuerschaltkreis-Schicht (110) eine Vielzahl von Steuerblöcken (111) umfasst, die jeweils mit jeder Speicherbank (122) entsprechend verbunden sind; und
wobei jede der Bitleitungen (BL) mit dem Steuerblock (111) und einer Vielzahl von Gruppen von Speicherzellen (130) in der Vielzahl von Speicherbänken (122) verbunden ist.

8. Speicher nach Anspruch 7, **dadurch gekennzeichnet, dass** ein Bereich, in dem sich der Steuerblock (111) befindet, sich zumindest teilweise mit einem Projektionsbereich der Speicherbank (122), mit der der Steuerblock (111) verbunden ist, auf der Steuerschaltkreis-Schicht (110) überlappt.

9. Speicher nach Anspruch 7, wobei der Steuerblock (111) durch Folgendes gekennzeichnet ist:
einen ersten Steuerblock, der mit der Bitleitung (BL) verbunden ist.

10. Speicher nach Anspruch 7, **dadurch gekennzeichnet, dass** die Gate-Strukturen (135) der Vielzahl von Speicherzellen (130) in der Speicherbank (122), die auf einer gleichen Geraden liegen, die sich in einer vierten Richtung erstreckt, miteinander verbunden und mit dem Steuerblock (111) verbunden sind; und wobei die vierte Richtung parallel zur Oberfläche des Substrats (100) verläuft.

11. Speicher nach Anspruch 10, wobei der Steuerblock (111) durch Folgendes gekennzeichnet ist:
einen zweiten Steuerblock, der mit der Gate-Struktur (135) verbunden ist.

12. Speichersystem (20), das durch Folgendes gekennzeichnet ist:
den Speicher (10) nach einem der Ansprüche 1 bis 11; und
eine Speichersteuerung (21).

## Revendications

1. Mémoire (10), comprenant :
un substrat (100) ;
une couche de circuit de commande (110) située dans le substrat (100), la couche de circuit de commande (110) comprenant au moins une partie des circuits de commande de la mémoire (10) ; et
au moins deux couches de structure de stockage (120), les au moins deux couches de structure de stockage (120) étant empilées de façon séquentielle sur la couche de circuit de commande (110) dans une première direction (Z),
la première direction étant perpendiculaire à une surface du substrat (100), et la couche de structure de stockage (120) étant raccordée à la couche de circuit de commande (110) ;
la couche de structure de stockage (120) comprenant une pluralité de cellules de mémoire (130) agencées en réseau, la cellule de mémoire (130) comprenant une structure de stockage (132) et au moins deux transistors de sélection raccordés en série (131) raccordés à la structure de stockage (132), et les au moins deux transistors de sélection raccordés en série (131) étant empilés dans la première direction ;
une structure de canal (133) du transistor de sélection (131) comprenant au moins une couche de nanofeuilles (134) s'étendant dans une deuxième direction (Y),
et la deuxième direction étant parallèle à la surface du substrat (100) ; et
les au moins deux transistors de sélection raccordés en série (131) partageant une structure de grille (135) ;
dans laquelle la cellule de mémoire (130) comprend en outre :
une première structure de source/drain (137a) et une deuxième structure de source/drain (137b), respectivement situées aux premières terminaisons des structures de canal (133) de deux des transistors de sélection (131) dans la deuxième direction, la première structure de source/drain (137a) et la deuxième structure de source/drain (137b) étant empilées dans la première direction ; et
une troisième structure de source/drain (136), située aux deuxièmes terminaisons des structures de canal (133) des deux transistors de sélection (131) dans la deuxième direction, les deux transistors de sélection (131) étant raccordés en série via la troisième structure de source/drain (136) ; et
la première structure de source/drain (137a) et la deuxième structure de source/drain (137b) sont respectivement raccordées aux nanofeuilles (134) dans les deux transistors de sélection raccordés en série (131), et la structure de stockage (132) est raccordée à la première structure de source/drain (137a) ;
**caractérisée en ce que** la mémoire comprend en outre
une première ligne de raccordement (141), située entre deux couches de structures de stockage adjacentes (120), dans laquelle les deuxièmes structures de source/drain (137b) de deux cellules de mémoire adjacentes (130) dans la première direction sont raccordées via la première ligne de raccordement (141) ;
une couche de structure de ligne de bits (140), située entre la couche de stockage la plus basse (120) et la couche de circuit de commande (110), dans laquelle la couche de structure de ligne de bits (140) comprend une pluralité de lignes de bits, bit lines (BL), parallèles s'étendant dans une troisième direction (X),
la troisième direction est parallèle à la surface du substrat (100) ; et
chaque ligne de bits (BL) est raccordée à une pluralité de groupes de cellules de mémoire (130) agencée dans la troisième direction, chaque groupe de cellules de mémoire (130) étant une pluralité de cellules de mémoire (130) qui sont empilées dans une direction perpendiculaire à la surface du substrat (100) et qui sont raccordées via la première ligne de raccordement (141).

2. Mémoire selon la revendication 1, **caractérisée en ce que**, des projections des nanofeuilles (134) dans les au moins deux transistors de sélection raccordés en série (131) sur le substrat (100) se chevauchent.

3. Mémoire selon la revendication 1, **caractérisée en ce que**, il y a un espace entre deux couches adjacentes de nanofeuilles (134) dans la première direction ; et la structure de grille (135) entoure chaque couche de nanofeuilles (134) via l'espace.

4. Mémoire selon la revendication 1, la structure de stockage (132) **caractérisée en ce qu'**elle comprend :
un condensateur de stockage (138), situé au-dessus de la première structure de source/drain (137a), une région projetée du condensateur de stockage (138) sur le transistor de sélection (131) chevauchant au moins partiellement une région dans laquelle le transistor de sélection (131) est situé ; et
une première structure de raccordement (139), raccordée entre le condensateur de stockage (138) et la première structure de source/drain (137a).

5. Mémoire selon la revendication 1, **caractérisée en ce que**, les deuxièmes structures de source/drain (137b) de deux cellules de mémoire adjacentes (130) dans la deuxième direction sont raccordées à une même première ligne de raccordement (141) ; et
les deux cellules de mémoire (130) raccordées à une même première ligne de raccordement (141) et adjacentes dans la deuxième direction sont placées symétriquement par rapport à la première ligne de raccordement (141).

6. Mémoire selon la revendication 5, **caractérisée en ce que**, les deuxièmes structures de source/drain (137b) de deux cellules de mémoire adjacentes (130) dans la deuxième direction sont raccordées à la même première ligne de raccordement (141) via une deuxième structure de raccordement (121) ; et
une zone projetée de la deuxième structure de raccordement (121) sur le substrat (100) est plus grande que la zone projetée de la première ligne de raccordement (141) sur le substrat (100).

7. Mémoire selon la revendication 1, la couche de structure de stockage (120) **caractérisée en ce qu'**elle comprend une pluralité de banques de mémoire (122) ; la banque de mémoire (122) comprend une pluralité de cellules de mémoire (130) ;
la couche de circuit de commande (110) comprend une pluralité de blocs de commande (111) raccordés de façon correspondante à chaque banque de mémoire (122) ; et
chaque ligne de bits, bit lines (BL), est raccordée au bloc de commande (111) et à une pluralité de groupes de cellules de mémoire (130) dans la pluralité de banques de mémoire (122).

8. Mémoire selon la revendication 7, **caractérisée en ce que**, une région dans laquelle le bloc de commande (111) est situé chevauche au moins partiellement une région projetée, sur la couche de circuit de commande (110), de la banque de mémoire (122) à laquelle le bloc de commande (111) est raccordé.

9. Mémoire selon la revendication 7, le bloc de commande (111) **caractérisé en ce qu'**il comprend :
un premier bloc de commande raccordé à la ligne de bits, bit line (BL).

10. Mémoire selon la revendication 7, **caractérisée en ce que**, les structures de grilles (135) de la pluralité de cellules de mémoire (130), dans la banque de mémoire (122), situées sur une même ligne droite s'étendant dans une quatrième direction sont interconnectées et raccordées au bloc de commande (111) ; et la quatrième direction est parallèle à la surface du substrat (100).

11. Mémoire selon la revendication 10, le bloc de commande (111) **caractérisé en ce qu'**il comprend :
un deuxième bloc de commande raccordé à la structure de grille (135).

12. Système de stockage (20), **caractérisé en ce qu'**il comprend :
la mémoire (10) selon l'une quelconque des revendications 1 à 11 ; et
un contrôleur de stockage (21).
